# DEMANDE DE BREVET EUROPEEN

(11) **EP 4 560 634 A1**
(43) Date de publication de la demande: **28.05.2025**
(21) Numéro de dépôt: 24212282.8
(22) Date de dépôt: 12.11.2024
(51) Int. Cl.: G11C 11/00, G11C 11/56, G11C 13/00, G11C 17/18

(54) **PROCÉDÉ DE CONFIGURATION D'UNE MÉMOIRE NON VOLATILE À CHANGEMENT DE PHASE**

(30) Priorité: 21.11.2023 FR 2312769
(71) Demandeur: STMicroelectronics International N.V., 1228 Plan-les-Ouates, Geneva (CH)
(72) Inventeur: BENHAMMADI, Jawad, 38800 PONT DE CLAIX (FR)
(74) Mandataire: Cabinet Beaumont

(57) **Abrégé**

La présente description concerne un procédé de configuration d'une mémoire non volatile à changement de phase, comprenant la partition de ladite mémoire en un premier ensemble d'une ou plusieurs régions ayant un premier nombre maximal de cycles d'écriture et un deuxième ensemble d'une ou plusieurs autres régions ayant un deuxième nombre maximal de cycles d'écriture supérieur au premier nombre maximal de cycles d'écriture, les premiers et deuxièmes nombres maximaux de cycles d'écriture étant liés à des paramètres physiques d'écriture différents.

## Description

### Domaine technique

La présente description concerne de façon générale les procédés de configuration de mémoires non volatile à changement de phase ainsi que les microcontrôleurs mettant en oeuvre ces procédés.

### Technique antérieure

Les mémoires non volatiles à changement de phase incorporées dans des microcontrôleurs sont potentiellement sensibles à des hautes températures comme celles utilisées lors d'étapes de soudures. Cela peut engendrer l'altération des données écrites dans la mémoire préalablement à l'étape de soudure. Il est en outre difficile de prédire à quel moment de la vie du microcontrôleur aura lieu l'étape de soudure.

### Résumé de l'invention

Il existe un besoin de fournir un procédé pour configurer la mémoire non volatile à changement de phase d'un microcontrôleur de sorte à adresser les cas où le microcontrôleur est soudé avant ou après l'écriture de données dans la mémoire tout en conservant un nombre maximal de cycles d'écriture satisfaisant.

Un mode de réalisation pallie tout ou partie des inconvénients des procédés connus.

Un mode de réalisation prévoit un procédé de configuration d'une mémoire non volatile à changement de phase, comprenant la partition de ladite mémoire en un premier ensemble d'une ou plusieurs régions ayant un premier nombre maximal de cycles d'écriture et un deuxième ensemble d'une ou plusieurs autres régions ayant un deuxième nombre maximal de cycles d'écriture supérieur au premier nombre maximal de cycles d'écriture, les premiers et deuxièmes nombres maximaux de cycles d'écriture étant liés à des paramètres physiques d'écriture différents.

Un mode de réalisation prévoit un microcontrôleur doté d'une mémoire non volatile à changement de phase, configuré pour mettre en oeuvre une partition de ladite mémoire en un premier ensemble d'une ou plusieurs régions ayant un premier nombre maximal de cycles d'écriture et un deuxième ensemble d'une ou plusieurs autres régions ayant un deuxième nombre maximal de cycles d'écriture supérieur au premier nombre maximal de cycles d'écriture, les premiers et deuxièmes nombre maximaux de cycles d'écriture étant liés à des paramètres physiques d'écriture différents.

Selon un mode de réalisation, le premier nombre maximal de cycles d'écriture correspond à l'utilisation d'un premier mode d'écriture et le deuxième nombre maximal de cycles d'écriture correspond à l'utilisation d'un deuxième mode d'écriture.

Selon un mode de réalisation, la partition et l'utilisation du premier et du deuxième mode d'écriture sont mises en oeuvre par une interface de mémoire.

Selon un mode de réalisation, lorsque le premier mode d'écriture est utilisé, une donnée écrite avant une étape de soudure du microcontrôleur est conservée stable pendant ladite étape de soudure.

Selon un mode de réalisation, lorsque le deuxième mode d'écriture est utilisé, une valeur écrite avant une étape de soudure du microcontrôleur, n'est pas conservée stable pendant ladite étape de soudure.

Selon un mode de réalisation, le deuxième nombre maximal de cycles d'écriture est au moins cinq fois supérieur au premier nombre maximal de cycles d'écriture.

Selon un mode de réalisation, la cristallinité de secteurs mémoire de régions des premier et deuxième ensembles, est différente, après écriture, selon l'utilisation du premier ou du deuxième mode d'écriture.

Selon un mode de réalisation, l'utilisation du premier ou deuxième mode d'écriture est définie pour chaque région de chaque ensemble par un ou des octets de configuration.

Selon un mode de réalisation, la définition de l'utilisation du premier ou du deuxième mode d'écriture est mise en oeuvre avec un registre d'association d'octets lié avec le ou les octets de configuration.

Selon un mode de réalisation, lorsque l'utilisation du premier mode d'écriture a été définie pour une ou des régions d'un des ensembles et que cette ou ces régions correspondent à une application nécessitant un nombre Nappli de cycles d'écriture supérieur au premier nombre maximal de cycles d'écriture, alors la ou lesdites régions sont divisées en N secteurs mémoire dans lesquels des données de l'application sont écrites successivement ;
N étant supérieur ou égal au rapport entre Nappli et le premier nombre maximal de cycles d'écriture.

Selon un mode de réalisation, les N secteurs mémoire ont leur adresse respective indexée et lorsqu'une des données de l'application est écrite dans le secteur mémoire d'index N, alors la donnée suivante est écrite dans le secteur d'index le plus faible.

Selon un mode de réalisation, après écriture d'une région en utilisant le deuxième mode d'écriture, ladite région peut être réécrite en utilisant le premier mode d'écriture.

Selon un mode de réalisation, après écriture d'une région en utilisant le premier mode d'écriture, ladite région ne peut pas être réécrite en utilisant le deuxième mode d'écriture.

Selon un mode de réalisation, le premier mode d'écriture comprend l'application d'un premier niveau de tension, de courant ou de puissance ; et
le deuxième mode d'écriture comprend l'application d'un deuxième niveau de tension, de courant ou de puissance différent du premier niveau de tension, de courant ou de puissance.

Selon un mode de réalisation, le premier niveau de tension, de courant ou de puissance est supérieur au deuxième niveau de tension, de courant ou de puissance.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un exemple de microcontrôleur du type auquel s'appliquent les modes de réalisation décrits ;
la figure 2 représente sous forme de blocs un procédé de configuration d'un bloc de la figure 1 selon un mode de réalisation ;
la figure 3 représente sous forme de blocs un procédé de configuration d'un bloc de la figure 1 selon un autre mode de réalisation ;
la figure 4 représente, de façon très schématique, un exemple d'un bloc du microcontrôleur selon un mode de réalisation ;
la figure 5 représente sous forme de blocs un procédé de configuration d'un bloc de la figure 4 ;
la figure 6 représente de façon très schématique, un exemple d'un bloc de la figure 4 ;
la figure 7 représente sous forme de blocs un procédé de configuration et d'écriture du bloc de la figure 6 ; et
la figure 8 représente sous forme de blocs un autre procédé de configuration et d'écriture du bloc de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

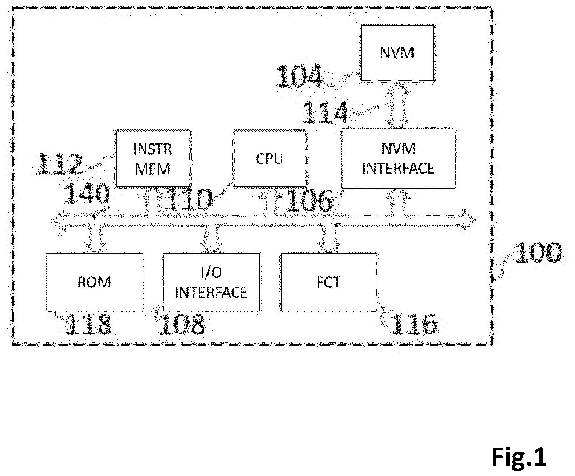

La figure 1 représente, de façon très schématique et sous forme de blocs, un exemple de microcontrôleur 100 du type auquel s'appliquent les modes de réalisation décrits. Le microcontrôleur 100 est par exemple un microcontrôleur.

Le microcontrôleur 100 comprend une mémoire non-volatile 104 (NVM), par exemple de type à changement de phase, capable de communiquer, via un bus de communication 114, avec une interface de mémoire non-volatile 106 (NVM INTERFACE) configurée pour écrire ou lire des données dans et depuis la mémoire non-volatile 104.

Le microcontrôleur 100 comprend en outre, par exemple, une unité de traitement 110 (CPU) comprenant un ou plusieurs processeurs sous contrôle d'instructions stockées dans une mémoire d'instructions 112 (INSTR MEM). La mémoire d'instruction 112 est par exemple une mémoire volatile de type à accès aléatoire (en anglais Random Access Memory, RAM). L'unité de traitement 110 et la mémoire 112 communiquent, par exemple, via un bus système 140 (de données, d'adresses et de commande). La mémoire 104 est reliée au bus système 140 par l'intermédiaire de l'interface de mémoire non-volatile 106 et par l'intermédiaire du bus 114. Le dispositif 100 comprend en outre une interface d'entrée/sortie 108 (I/O interface) reliée au bus système 140 pour communiquer avec l'extérieur.

Le microcontrôleur 100 peut intégrer d'autres circuits mettant en oeuvre d'autres fonctions (par exemple, une ou plusieurs mémoires volatiles et/ou non-volatiles, ou d'autres unités de traitement), symbolisées par un bloc 116 (FCT) en figure 1. Parmi ces autres circuits, le microcontrôleur 100 comporte par exemple une mémoire morte ou statique 118 (ROM).

La mémoire 104 est par exemple partitionnée en différentes régions comprenant un ou plusieurs secteurs mémoire. Dans une mémoire 104 à changement de phase, ces secteurs peuvent être réécrits directement sans nécessiter de d'opération d'effacement préalable. L'écriture dans ces secteurs est réalisée en changeant leur résistance par exemple par l'application de paramètres physiques d'écriture tels qu'une tension ou un courant au moment de l'écriture.

Plusieurs modes d'écriture ont récemment été développés pour écrire des données dans les secteurs mémoire des mémoires à changement de phase. Certains modes d'écriture permettent un nombre maximal de cycles d'écriture élevé, par exemple de l'ordre de 10000 cycles, tandis que d'autres cycles d'écriture permettent un nombre maximal de cycles d'écriture moins élevé, par exemple de l'ordre de 1000 cycles mais avec une tenue en température plus élevée. Les performances en termes de cyclage des différents modes d'écriture sont liées par exemple à un changement de cristallinité des secteurs mémoires en fonction du mode d'écriture choisi. Par le terme cristallinité on entend de façon similaire un arrangement atomique, par exemple une orientation de plans atomiques, des paramètres de maille, ou encore un caractère amorphe, multicristallin ou monocristallin. Les secteurs écrits avec les modes d'écriture permettant un nombre maximal de cycles d'écriture élevé (e.g. 10000 cycles) sont cependant plus sensibles à des hautes températures telles que celles atteintes dans le microcontrôleur 100 lorsqu'il est soudé. Il se peut ainsi que des données écrites dans les modes d'écriture permettant un cyclage élevé soient corrompues ou effacées, autrement dit ne sont pas robustes, lorsque le microcontrôleur est soudé.

Les différentes régions de la mémoire 104 sont par exemple utilisées par différentes applications mises en oeuvre par le microcontrôleur 100. Chaque type d'application peut nécessiter un nombre maximal de cyclage différent. Certaines applications peuvent également être mises en oeuvre en usine par le fabricant du microcontrôleur et d'autres chargées par des prestataires externes qui souderont le microcontrôleur dans un produit avant ou après écriture des données. Il est donc difficile de prédire à quel moment le microcontrôleur sera soudé.

D'autre part, les mémoires non volatiles classiques, c'est-à-dire celles qui ne sont pas à changement de phase, permettent un cyclage en écriture élevé sans être toutefois sensibles outre mesure à la température. Il convient donc de permettre aux clients ou prestataires une utilisation des mémoires à changement de phase qui se rapproche de l'utilisation des mémoires non volatiles classiques.

Les modes de réalisation décrits proposent la partition de la mémoire 104 en un premier ensemble d'une ou plusieurs régions ayant un premier nombre maximal de cycles d'écriture et un deuxième ensemble d'une ou plusieurs autres régions ayant un deuxième nombre maximal de cycles d'écriture supérieur au premier nombre maximal de cycles d'écriture, les premiers et deuxièmes nombres maximaux de cycles d'écriture étant liés à des paramètres physiques d'écriture différents.

Cela permet de mettre à profit les avantages des mémoires à changement de phase tels que l'absence de nécessité d'effacement avant réécriture tout en offrant une flexibilité du choix du mode d'écriture aux différents clients ou prestataires utilisant le microcontrôleur 100. Il est ainsi par exemple possible de choisir, pour une région donnée de la mémoire, un mode d'écriture résistant à la soudure, et pour une autre région, un autre mode d'écriture qui n'est certes pas robuste vis-à-vis de l'étape de soudure, mais qui est tout de façon mis en oeuvre après la soudure.

Un mode de réalisation permet en outre d'obtenir un nombre maximal de cycles d'écriture similaire à une mémoire non volatile classique tout en s'assurant que les données écrites avant la soudure seront gardées robustes.

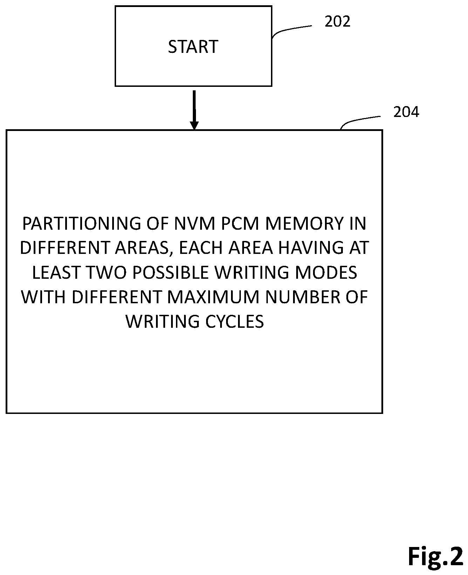

La figure 2 représente sous forme de blocs un procédé de configuration d'un bloc de la figure 1 selon un mode de réalisation. Plus particulièrement, la figure 2 illustre un procédé de configuration de la mémoire 104.

Dans une première étape 202 (START), le procédé de configuration de la mémoire 104 commence et est mis en oeuvre, par exemple à l'aide de l'interface mémoire 106.

Dans une deuxième étape 204 (PARTITIONING OF NVM PCM MEMORY IN DIFFERENT AREAS, EACH AREA HAVING AT LEAST TWO POSSIBLE WRITING MODES WITH DIFFERENT MAXIMUM NUMBER OF WRITING CYCLES), la mémoire 104 est divisée, par exemple en utilisant l'interface mémoire 106, en une ou plusieurs régions ayant chacune plusieurs modes d'écriture possibles. La ou les régions sont composées chacune d'un ou plusieurs secteurs mémoire. En d'autres termes, la mémoire 104 est partionnée en plusieurs régions ayant chacune plusieurs modes d'écriture possible, chaque mode d'écriture permettant un nombre maximal de cycles d'écriture des secteurs mémoire ainsi qu'une tenue en température des données qui lui sont propres.

Dans un exemple, un premier mode d'écriture (power mode) permet qu'une donnée écrite avant une étape de soudure du microcontrôleur 100 dans un secteur mémoire d'une des régions de la mémoire 104, soit conservée stable pendant l'étape de soudure du microcontrôleur 100. Le premier mode d'écriture est par exemple obtenu par application d'un premier niveau de tension, d'un premier niveau de courant ou d'un premier niveau de puissance électrique. Ces premiers niveaux de tension, de courant ou de puissance peuvent également comprendre des variations de tension, de courant ou de puissance.

Dans un exemple d'un deuxième mode d'écriture (user mode), une donnée écrite dans un secteur mémoire, avant une étape de soudure du microcontrôleur, n'est pas conservée stable pendant l'étape de soudure. Cette différence de tenue en température entre le premier mode et le deuxième mode est par exemple due au fait que le premier mode (power mode) met en oeuvre une ou des tensions, des courants ou des puissances supérieures à ceux mis en oeuvre pour le deuxième mode (user mode). Le deuxième mode d'écriture est par exemple obtenu par application d'un deuxième niveau de tension, d'un deuxième niveau de courant ou d'un deuxième niveau de puissance électrique différents, par exemple inférieurs, au premier niveau de tension, courant ou puissance. Ces deuxièmes niveaux de tension, de courant ou de puissance peuvent également comprendre des variations de tension, de courant ou de puissance. Dans un exemple, la résistivité de secteurs mémoire d'une région obtenue avec le deuxième mode d'écriture, est différente de la résistivité obtenue avec le premier mode d'écriture.

Dans un exemple, le deuxième mode d'écriture (user mode) permet un nombre maximal de cycles d'écriture plus élevé que le premier mode (power mode), par exemple supérieur à cinq fois. Le deuxième mode d'écriture (user mode) permet un nombre maximal de cycles d'écriture par exemple de l'ordre de 10000 cycles, tandis que le premier cycle d'écriture (power mode) permet un nombre maximal de cycles d'écriture, par exemple de l'ordre de 1000 cycles, mais avec une tenue en température des données écrites plus importante.

La différence entre le nombre maximal de cycles d'écriture atteignable par le premier mode d'écriture et le deuxième mode d'écriture est par exemple due aux différences entre les premier et deuxième modes de tension ou courant.

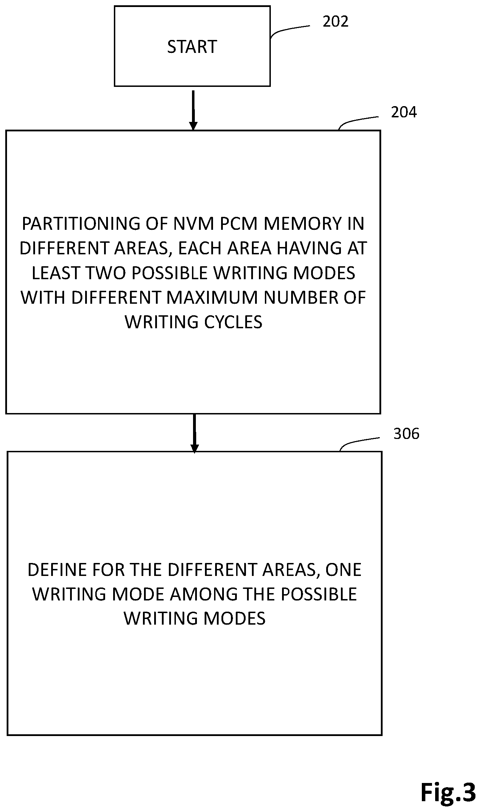

La figure 3 représente sous forme de blocs un procédé de configuration d'un bloc de la figure 1 selon un autre mode de réalisation. Le procédé de la figure 3 est similaire au procédé de la figure 2 mais avec une étape supplémentaire 306 (DEFINE FOR THE DIFFERENT AREAS, ONE WRITING MODE AMONG THE POSSIBLE WRITING MODES) mise en oeuvre après l'étape 204.

Dans l'étape 306, un mode d'écriture, parmi les modes d'écriture possibles, par exemple soit le premier soit le deuxième mode, est défini, autrement dit sélectionné, pour chaque région de la mémoire 104. Cette définition est par exemple mise en oeuvre par l'interface de mémoire 106.

Par le terme désignation, on signifie que chaque région se voit affecter un mode d'écriture sélectionné parmi le premier ou le deuxième mode d'écriture par exemple. La sélection du mode d'écriture se fait par exemple par le changement d'un octet de configuration (option byte en anglais).

Dans le cas où le premier mode d'écriture modifie de façon définitive la cristallinité des secteurs mémoires, après l'écriture de secteurs mémoire d'une région définie avec le premier mode d'écriture (power mode), ces secteurs ne peuvent pas être réécrits lorsque ladite région est ensuite définie avec le deuxième mode d'écriture (user mode).

A l'inverse, dans le cas où le deuxième mode d'écriture (user mode) ne modifie pas de façon définitive la cristallinité des secteurs mémoires, après l'écriture de secteurs mémoire d'une région définie avec le deuxième mode d'écriture (user mode), ces secteurs peuvent être réécrits si ladite région est ensuite définie avec le premier mode d'écriture (power mode).

Le procédé de la figure 3 donne la possibilité de désigner ou d'affecter, pour chaque région, le premier ou le deuxième mode d'écriture par exemple tout en permettant l'utilisation du microcontrôleur par plusieurs prestataires ou clients successifs.

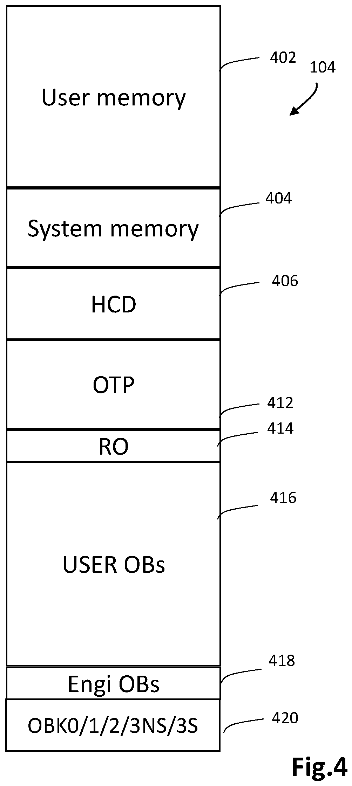

La figure 4 représente, de façon très schématique, un exemple d'un bloc du microcontrôleur 100 selon un mode de réalisation.

Plus particulièrement, la figure 4 représente un exemple de partition de la mémoire 104 en des régions 402 (User memory), 404 (System memory), 406 (HCD), 408 (OBK1/2/3), 410 (OBKO), 412 (OTP), 414 (RO), 416 (USER OBs) et 418 (Engi Obs) . Le mode d'écriture défini pour chacune des régions de l'exemple de la figure 4 dépend de l'utilisation des régions par exemple par différentes applications.

La région 402 comprend par exemple plusieurs sous parties, chaque sous partie étant définie avec un des modes d'écriture. Dans un exemple, chaque sous partie correspond à un groupe de plusieurs secteurs, par exemple quatre. Pour la définition du mode d'écriture de chaque sous partie, un registre d'association d'octets (bitmap en anglais) est par exemple utilisé en association avec le ou les octets de configuration. Dans un exemple, la mise à 0 ou à 1 d'un bit ou d'un octet de configuration du registre d'association d'octets, correspond à la définition du mode d'écriture choisi pour la sous partie correspondante audit bit ou octet. Dans un exemple, le registre d'association d'octets est appelé NVM_WRMyR. Dans cet exemple, une première sous partie est notée NVM_WRMyR [0], une deuxième est notée NVM_WRMyR [1] et une troisième est notée NVM_WRMyR [2], etc. Le registre d'association d'octets associe un bit ou octet représentant le premier ou le deuxième mode d'écriture (par exemple 0 pour le premier mode et 1 pour le deuxième) à chacune des sous parties de la région 402.

La région 404 est par exemple utilisée par une application dont les données sont écrites par le fabricant du microcontrôleur 100. De plus la région 404 n'étant pas censée être réécrite, elle ne nécessite qu'une faible capacité de cyclage en écriture. Une étape de soudure sera sans doute mise en oeuvre ultérieurement dans la vie du microcontrôleur. La région 404 est donc par exemple définie avec le premier mode d'écriture pour que les données puissent être conservées pendant l'étape de soudure.

La région 406 est utilisée par exemple par une application qui nécessite un nombre important de cycles d'écriture. La région 406 est donc définie avec le deuxième mode d'écriture. Dans un exemple, cette définition du mode d'écriture est codée en dur dès la fabrication du microcontrôleur de façon à n'être pas modifiable par un programme.

La région 412 correspond par exemple à des données écrites une seule fois (One Time Programmable data en anglais). Le faible niveau de cyclage nécessaire permet donc d'utiliser pour cette région le premier mode d'écriture (power mode).

La région 414 correspond par exemple à des données qui ne peuvent qu'être lues (Read Only Data en anglais) . Le faible niveau de cyclage d'écriture nécessaire permet donc d'utiliser pour cette région 414 le premier mode d'écriture (power mode).

La région 416 correspond par exemple à des données qui sont écrites par le fabricant du microcontrôleur mais qui peuvent être mises à jour par un prestataire externe durant la vie du microcontrôleur par exemple. En d'autres termes, le microcontrôleur est susceptible d'être soudé après l'écriture des données par le fabricant. Le mode d'écriture défini pour cette région doit donc être le premier mode d'écriture (power mode). Néanmoins, il peut être nécessaire que les mise à jour des données dans cette région restent possible durant toute la vie du microcontrôleur 100. Par exemple, certaines applications nécessitent qu'un plus grand nombre Nappli, par exemple 10000, de cycles d'écritures soient réalisables.

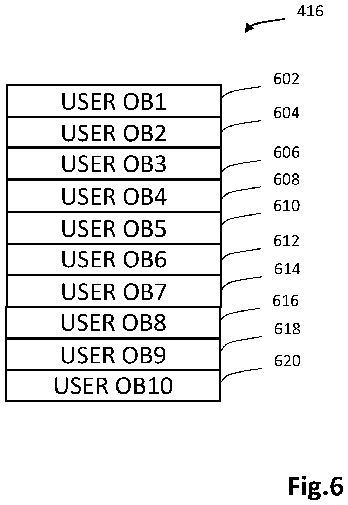

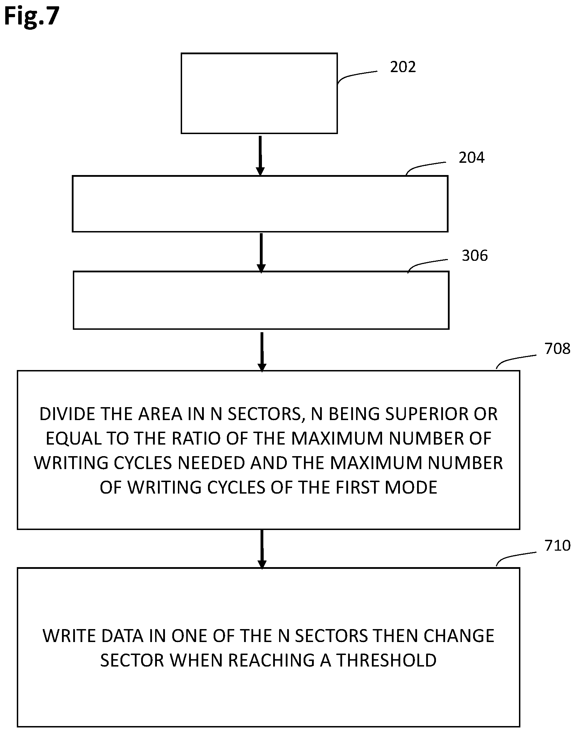

Les modes de réalisation décrits dans la figure 6 et 7 permettent d'adresser ce problème.

La région 418 est par exemple programmée par le fabricant avec des données qui correspondent par exemple à des données de fabrication ou de débogage issues par le fabricant. Le nombre de cycles d'écriture dans la vie du microcontrôleur est réduit et la région 418 est donc définie avec le premier mode d'écriture (power mode) pour supporter l'étape de soudure.

La région 420 comprend par exemple cinq sous parties OBKO, OBK1, OBK2, OBK3NS et OBK3S qui comprennent des clés d'octets de configuration qui correspondent à des clés de sécurité pour des prestataires différents par exemple. Ces clés d'octets de configuration sont programmables par exemple par différents prestataires externes au fabricant. Il est par exemple possible de permettre que les quatre sous parties OBK1, OBK2 OBK3NS et OBK3S puissent être définies avec un mode d'écriture programmable après la fabrication ce qui permet de gagner en flexibilité d'utilisation.

La sous partie OBKO est par exemple programmée par le fabricant avec des données qui doivent rester robustes pendant toute la vie du microcontrôleur 100. La sous partie OBKO est donc définie avec le premier mode d'écriture (power mode). Dans un exemple, cette définition du mode d'écriture est codée en dur dès la fabrication du microcontrôleur de façon à n'être pas modifiable par un programme.

Dans un exemple non représenté, toutes les sous parties OBK1, OBK2, OBK3NS et OBK3S, comprennent deux secteurs, un secteur courant qui contient les valeurs valides de toutes les clés de sécurité des sous parties OBK1, OBK2, OBK3NS et OBK3S et un secteur de substitution utilisé pour mettre à jour ces clés. Pour mettre à jour une clé dans une des sous parties, le secteur de substitution est sélectionné, par exemple avec la mise en oeuvre d'un registre dédié, puis la nouvelle clé est écrite, par voie logicielle par exemple, dans le secteur de substitution et les clés valides des autres sous parties sont copiées dans le secteur de substitution par exemple par une machine d'état associée à une commande appelée par exemple OBKSWAP. La commande OBKSWAP est mise en oeuvre, par exemple par l'interface mémoire 106, pour échanger le rôle des deux secteurs. Le secteur de substitution devient ainsi le secteur courant où la donnée de la nouvelle clé est valide. Puisque les sous parties OBK1, OBK2, OBK3NS et OBK3S, peuvent être définies avec des modes d'écriture différents et utilisées avec un nombre de cycles d'écriture différents, il n'est pas recommandé de mettre à jour toutes les sous-parties chaque fois qu'une clé d'une seule des sous parties doit être mise à jour. Par exemple, si les sous parties OBKO et OBK1 sont programmées avec le premier mode d'écriture (power mode) et que les autres sous parties sont programmées avec le deuxième mode (user mode), alors si l'utilisateur met à jour mille fois la clé dans OBK2 alors les sous parties OBKO et OBK1 cyclent également mille fois ce qui devient dommageable avec le premier mode d'écriture.

Il est donc nécessaire de fournir un procédé différent pour l'écriture des sous parties de la région 420 qui soit compatible avec le fait que plusieurs modes d'écriture sont possiblement définis pour les différentes sous parties OBKO, OBK1, OBK2, OBK3NS et OBK3S,

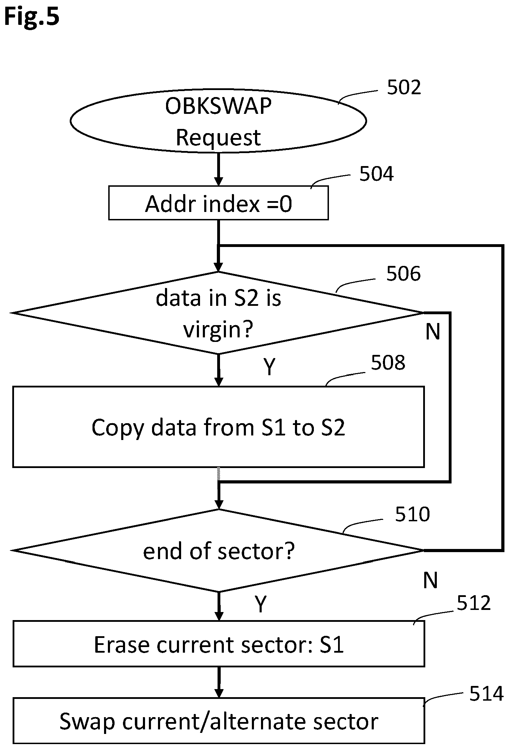

La figure 5 représente sous forme de blocs un procédé de configuration d'un bloc de la figure 4 selon un mode de réalisation. Plus particulièrement, la figure 5 illustre un procédé d'écriture dans les sous parties OBK1, OBK2, OBK3NS et OBK3S de la région 420.

Le procédé de la figure 5 consiste en ce chaque sous partie OBKO, OBK1, OBK2, OBK3NS et OBK3S, soit gérée indépendamment pour la mise à jour des données avec deux secteurs propres à chacune des sous parties.

Puisque les sous parties OBK1, OBK2, OBK3NS et OBK3S, sont traitées, dans l'exemple de la figure 5, de façon indépendante, la figure 5 représente le procédé d'écriture d'une nouvelle clé dans une seule des sous parties, c'est-à-dire la sous partie qui est concernée par la mise à jour d'une des clés, les autres sous parties restant avec des secteurs inchangés.

Dans une étape 502 (OBKSWAP Request), le secteur courant est appelé S1 et le secteur de substitution est appelé S2. Dans cette étape, la commande appelée OBKSWAP est mise en oeuvre, par exemple avec une machine d'état.

Dans une étape 504 (Addr index=0), postérieure à l'étape 502, un index de l'adresse lue du secteur courant commence à zéro.

Dans une étape 506 (data in S2 is virgin ?), postérieure à l'étape 504, il est vérifié si l'adresse correspondant à l'index courant est vierge. Si oui (branche Y) alors une étape 508 (Copy data from S1 to S2) est mise en oeuvre. Si non, une étape 510 (end of sector?) est mise en oeuvre.

Dans l'étape 508, les données du secteur courant S1 sont copiées avec la clé mise à jour dans le secteur de substitution S2 puis l'étape 510 est mise en oeuvre.

Dans l'étape 510, si l'index d'adresse correspond à une adresse de fin du secteur (branche Y) alors une étape 512 (Erase current sector : S1) est mise en oeuvre. Si l'index ne correspond pas à une adresse de fin de secteur (branche N) alors l'index est incrémenté et le procédé recommence à l'étape 506.

Dans l'étape 512, le secteur courant S1 est effacé.

L'étape 512 est suivie d'une étape 514 (Swap current/alternate sector) dans laquelle le secteur courant S1 devient le secteur de substitution et le secteur de substitution S2 devient le secteur courant.

La figure 6 représente de façon très schématique, un exemple d'un bloc de la figure 4. La figure 6 représente plus particulièrement un exemple d'implémentation de la région 416 qui est, dans ce mode de réalisation, subdivisée en dix secteurs ou groupes de secteurs 602 (USER OB1), 604 (USER OB2), 606 (USER OB3), 608 (USER OB4), 610 (USER OB5), 612 (USER OB6), 614 (USER OB7), 616 (USER OB8), 618 (USER OB9) et 620 (USER OB10). Chaque secteur de la région 416 est défini avec le premier mode d'écriture.

Cet exemple d'implémentation, associé au procédé d'écriture décrit dans la figure suivante, permet à une application utilisant la région 416 de bénéficier de la robustesse des données écrites avec le premier mode d'écriture (power mode) tout en bénéficiant d'un nombre maximal de cycles d'écriture supérieur à celui disponible pour le premier mode d'écriture (power mode).

La figure 7 représente sous forme de blocs un procédé de configuration et d'écriture du bloc de la figure 6. Plus particulièrement, la figure 7 représente un procédé de configuration et d'écriture de la région 416 de la figure 6.

Le procédé de la figure 7 comprend les étapes 202, 204 et 306 similaires à l'exemple de la figure 3.

Dans une étape supplémentaire 708 (DIVIDE THE AREA IN N GROUPS OF SECTORS, N BEING SUPERIOR OR EQUAL TO THE RATIO OF THE MAXIMUM NUMBER OF WRITING CYCLES NEEDED AND THE MAXIMUM NUMBER OF WRITING CYCLES OF THE FIRST MODE), effectuée postérieurement à l'étape 306, si le nombre maximal Nappli de cycles d'écriture nécessaire pour une application utilisant la région 416, est supérieur au nombre maximal de cycles d'écriture du premier mode d'écriture (power mode), alors cette région est divisée en N secteurs mémoire dans lesquels des données de l'application sont écrites. N est par exemple supérieur ou égal au ratio entre Nappli et le nombre maximum de cycles d'écriture du premier mode d'écriture (power mode).

Dans une étape 710 (WRITE DATA IN ONE OF THE GROUP OF SECTORS THEN CHANGE SECTOR WHEN REACHING A THRESHOLD), postérieure à l'étape 708, un compteur comptabilise le nombre de cycles d'écriture ayant eu lieu dans chacun des N secteurs mémoire.

Dans un exemple, lorsque le compteur atteint un certain seuil pour un secteur, alors les données sont écrites dans un autre secteur. Dans un exemple, le secteur ayant le moins de données écrites devient le secteur où sont écrites de nouvelles données de l'application lorsque le compteur atteint ce seuil.

Les étapes 708 et 710 sont par exemple mises en oeuvre à l'aide de l'interface mémoire 106.

Chaque secteur de la région 416 ayant par exemple une capacité de 1000 cycles d'écritures due à l'utilisation du premier mode d'écriture (power mode), en passant d'un secteur à un autre, il est possible d'atteindre, pour la région 416 dans son ensemble, un nombre maximal de cycles d'écriture de 10000 (10*1000) cycles qui est bien supérieur au nombre maximal de cycles d'écriture du premier mode d'écriture (power mode) tout en conservant une robustesse des données écrites vis-à-vis d'une étape de soudure.

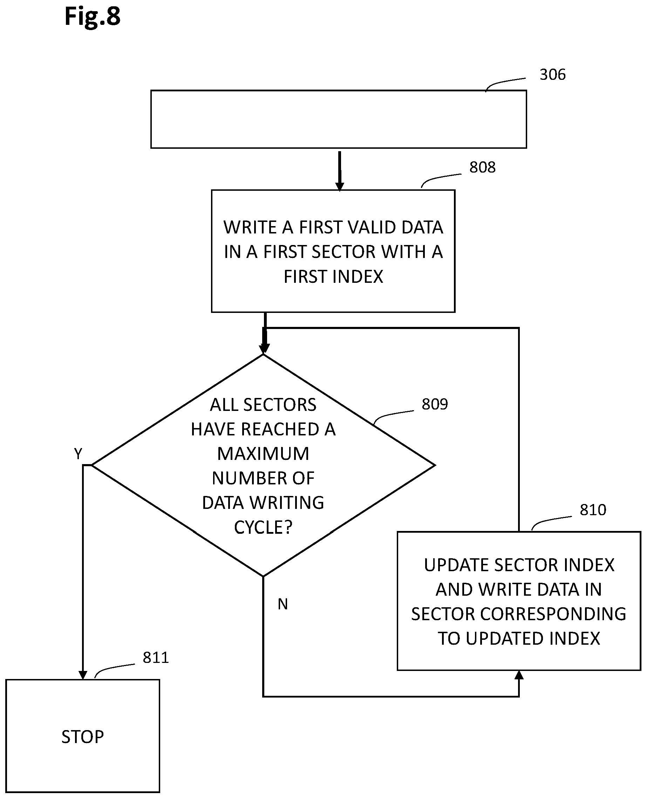

La figure 8 représente sous forme de blocs un autre procédé de configuration et d'écriture du bloc de la figure 6. Plus particulièrement, la figure 8 représente un procédé de configuration et d'écriture de la région 416 de la figure 6.

Le procédé de la figure 8 comprend les étapes 202, 204 et 306 similaires à l'exemple de la figure 3.

Dans une étape supplémentaire 808 (WRITE A FIRST VALID DATA IN A FIRST SECTOR WITH A FIRST INDEX), effectuée postérieurement à l'étape 306, une donnée valide est écrite, avec le premier mode d'écriture, dans un premier secteur ou groupe de secteurs de la région 416 dont l'adresse a un premier index. Cette donnée correspond par exemple à une clé de sécurité comme une clé d'octets de configuration.

Dans une étape 809 (ALL SECTORS HAVE REACHED A MAXIMUM NUMBER OF DATA WRITING CYCLE?) postérieure à l'étape 808, si les N secteurs ou groupes de secteurs de la région 416 ont été écrits un nombre de fois égal au nombre maximal de cycles d'écriture possible du premier mode d'écriture (branche Y) alors le procédé s'arrête avec une étape 811 (STOP). Dans le cas contraire (branche N), une étape 810 (UPDATE SECTOR INDEX AND WRITE DATA IN SECTOR CORRESPONDING TO UPDATED INDEX) est implémentée.

Dans l'étape 810, la donnée écrite précédemment dans le premier secteur n'est plus valide. Dans cette étape, l'index de l'adresse relative au secteur ou groupe de secteur de la région 416 est incrémenté sauf si l'index est égal au chiffre N défini dans la figure 7. Si l'index est égal à N alors l'index est remis à 0, par exemple à la façon d'une permutation circulaire. La nouvelle donnée valide est ensuite écrite, avec le premier mode d'écriture (power mode), dans le secteur ou groupe de secteurs de la région 416 dont l'adresse correspond à l'index mis à jour. Les N secteurs sont ainsi remplis chacun leur tour jusqu'à ce que le nombre maximal de cycles d'écriture lié à l'utilisation du premier mode d'écriture soit atteint pour chacun des secteurs.

L'étape 809 est ensuite de nouveau mise en oeuvre.

Les étapes 808, 809 et 810 sont par exemple mises en oeuvre à l'aide de l'interface mémoire 106.

Dans l'exemple où le nombre maximal de cycles d'écriture du premier mode est de 1000 cycles, il est ainsi possible d'atteindre, pour la région 416 dans son ensemble, un nombre maximal de cycles d'écriture de 10000 (10*1000) cycles qui est bien supérieur au nombre maximal de cycles d'écriture du premier mode d'écriture (power mode) tout en conservant une robustesse des données écrites vis-à-vis d'une étape de soudure.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, l'utilisation de registres d'association de bits peut être généralisée à l'ensemble des régions de la mémoire 104.

Enfin, la mise en oeuvre pratique des modes de réalisation et variantes décrits est à la portée de la personne du métier à partir des indications fonctionnelles données ci-dessus. En particulier, même si le procédé a été décrit dans le cas d'un microcontrôleur, la personne du métier pourra mettre en oeuvre ses connaissances pour appliquer ce procédé à d'autres types de circuits électroniques tels que des systèmes sur puce (System on chip, SOC, en anglais).

## Revendications

1. Procédé de configuration d'une mémoire (104) non volatile à changement de phase, comprenant la partition de ladite mémoire (104) en un premier ensemble d'une ou plusieurs régions (402, 404, 406, 408, 410, 412, 414, 416, 418) ayant un premier nombre maximal de cycles d'écriture et un deuxième ensemble d'une ou plusieurs autres régions (402, 404, 406, 408, 410, 412, 414, 416, 418) ayant un deuxième nombre maximal de cycles d'écriture supérieur au premier nombre maximal de cycles d'écriture, les premiers et deuxièmes nombres maximaux de cycles d'écriture étant liés à des paramètres physiques d'écriture différents.

2. Microcontrôleur (100) doté d'une mémoire (104) non volatile à changement de phase, configuré pour mettre en oeuvre une partition de ladite mémoire (104) en un premier ensemble d'une ou plusieurs régions (402, 404, 406, 408, 410, 412, 414, 416, 418) ayant un premier nombre maximal de cycles d'écriture et un deuxième ensemble d'une ou plusieurs autres régions (402, 404, 406, 408, 410, 412, 414, 416, 418) ayant un deuxième nombre maximal de cycles d'écriture supérieur au premier nombre maximal de cycles d'écriture, les premiers et deuxièmes nombre maximaux de cycles d'écriture étant liés à des paramètres physiques d'écriture différents.

3. Procédé selon la revendication 1, ou microcontrôleur (100) selon la revendication 2, dans lequel le premier nombre maximal de cycles d'écriture correspond à l'utilisation d'un premier mode d'écriture (power mode) et le deuxième nombre maximal de cycles d'écriture correspond à l'utilisation d'un deuxième mode d'écriture (user mode).

4. Procédé ou microcontrôleur selon la revendication 3, dans lequel la partition et l'utilisation du premier et du deuxième mode d'écriture sont mises en oeuvre par une interface de mémoire (106).

5. Procédé ou microcontrôleur selon la revendication 3 ou 4, dans lequel, lorsque le premier mode d'écriture (power mode) est utilisé, une donnée écrite avant une étape de soudure du microcontrôleur (100) est conservée stable pendant ladite étape de soudure.

6. Procédé ou microcontrôleur selon l'une quelconque des revendications 3 à 5, dans lequel, lorsque le deuxième mode d'écriture (user mode) est utilisé, une valeur écrite avant une étape de soudure du microcontrôleur (100), n'est pas conservée stable pendant ladite étape de soudure.

7. Procédé ou microcontrôleur selon l'une quelconque des revendications 1 à 6, dans lequel le deuxième nombre maximal de cycles d'écriture est au moins cinq fois supérieur au premier nombre maximal de cycles d'écriture.

8. Procédé ou microcontrôleur selon l'une quelconque des revendications 3 ou 4 à 7 dans leur dépendance à la revendication 3, dans lequel la cristallinité de secteurs mémoire de régions des premier et deuxième ensembles, est différente, après écriture, selon l'utilisation du premier ou du deuxième mode d'écriture.

9. Procédé ou microcontrôleur selon l'une quelconque des revendications 3 ou 4 à 8 dans leur dépendance à la revendication 3, dans lequel l'utilisation du premier ou deuxième mode d'écriture est définie pour chaque région de chaque ensemble par un ou des octets de configuration.

10. Procédé ou microcontrôleur selon la revendication 9, dans lequel la définition de l'utilisation du premier ou du deuxième mode d'écriture est mise en oeuvre avec un registre d'association d'octets lié avec le ou les octets de configuration.

11. Procédé ou microcontrôleur selon l'une quelconque des revendications 3, ou 4 à 10 dans leur dépendance à la revendication 3, dans lequel lorsque l'utilisation du premier mode d'écriture (power mode) a été définie pour une ou des régions d'un des ensembles et que cette ou ces régions correspondent à une application nécessitant un nombre Nappli de cycles d'écriture supérieur au premier nombre maximal de cycles d'écriture, alors la ou lesdites régions sont divisées en N secteurs mémoire (502, 504, 506, 508, 510, 512, 514, 516, 518, 520) dans lesquels des données de l'application sont écrites successivement ;
N étant supérieur ou égal au rapport entre Nappli et le premier nombre maximal de cycles d'écriture.

12. Procédé ou microcontrôleur selon la revendication 11, dans lequel les N secteurs mémoire ont leurs adresses respectives indexées et lorsqu'une des données de l'application est écrite dans le secteur mémoire d'index N, la donnée suivante est alors écrite dans le secteur d'index le plus faible.

13. Procédé ou microcontrôleur selon l'une quelconque des revendications 3 à 12 dans lequel, après écriture d'une région en utilisant le deuxième mode d'écriture (user mode), ladite région peut être réécrite en utilisant le premier mode d'écriture (power mode).

14. Procédé ou microcontrôleur selon l'une quelconque des revendications 3 à 13 dans lequel, après écriture d'une région en utilisant le premier mode d'écriture (power mode), ladite région ne peut pas être réécrite en utilisant le deuxième mode d'écriture (user mode).

15. Procédé ou microcontrôleur selon la revendication 3 ou selon l'une quelconque des revendications 4 à 14 dans leur dépendance à la revendication 3, dans lequel le premier mode d'écriture (power mode) comprend l'application d'un premier niveau de tension, de courant ou de puissance ; et
le deuxième mode d'écriture (user mode) comprend l'application d'un deuxième niveau de tension, de courant ou de puissance différent du premier niveau de tension, de courant ou de puissance.

16. Procédé ou microcontrôleur selon la revendication 15, dans lequel le premier niveau de tension, de courant ou de puissance est supérieur au deuxième niveau de tension, de courant ou de puissance.
